# FASCICULE DE BREVET EUROPEEN

(11) **EP 2 070 192 B1**
(45) Date de publication et mention de la délivrance du brevet: **24.03.2010**
(21) Numéro de dépôt: 07820969.9
(22) Date de dépôt: 05.10.2007
(51) Int. Cl.: H03H 7/01

(54) **FILTRE SUIVEUR RAPIDE**
SCHNELLES NACHLAUFFILTER
FAST TRACKING FILTER

(30) Priorité: 06.10.2006 FR 0608796
(43) Date de publication de la demande: 17.06.2009
(73) Titulaire: Thales, 92200 Neuilly Sur Seine (FR)
(72) Inventeur: POUPLIER, Marc, F-19360 Cosnac (FR)
(74) Mandataire: Dudouit, Isabelle
(86) Numéro de dépôt international: PCT/EP2007/060595
(87) Numéro de publication internationale: WO 2008/040801

(56) Documents cités:
- GB-A- 2 313 008
- JP-A- 2006 237 794
- US-A- 5 752 179

## Description

Le brevet concerne un filtre de la famille des filtres passe bande réalisés à partir de circuits oscillants (self capacité) couplés.

L'invention concerne un filtre HF tractable rapide, très linéaire, à bande passante constante dont le facteur de forme est optimum dans toute sa plage fréquentielle et à toute température confondue, grâce à des tensions de commandes séparées. Un tel filtre est divulgué dans le document GB-A-2 313 008.

Elle est utilisée, par exemple, dans tous les filtres à forte linéarité qui nécessitent un couplage à bande passante constante, c'est-à-dire qu'en fonction de la fréquence d'accord, la bande passante du filtre doit rester fixe. Elle est utilisée par exemple dans les équipements de radiocommunication, en particulier au niveau des filtres de tête HF des récepteurs agiles en sauts de fréquence soumis à des environnements fortement brouillés

Dans le domaine de la réception, les récepteurs sont confrontés à des environnements de plus en plus pollués par des émissions parasites indésirables. Pour que ces brouilleurs ne soient pas gênants, il est souhaitable de les éliminer ou de réduire leur influence par filtrage, mais à condition que les filtres n'engendrent pas de déformation du signal utile par manque de linéarité.

Le besoin environnemental nécessite de réduire l'influence de ces brouilleurs lorsqu'ils sont éloignés d'une constante par rapport au signal utile (et non en pourcentage), d'où la nécessité d'utiliser des filtres à bande passante fixe et non variable en fréquence. Ces filtres à bande passante constante, difficiles à réaliser nécessitent des couplages avec des éléments variables (type varicap par exemple), mais incompatibles avec la linéarité nécessaire.

Les caractéristiques habituellement utilisées pour quantifier la linéarité sont : le point de compression à 1 dB (I_{pc}) et le point d'interception d'ordre 3 (IP₃).

Une fonction non linéaire crée des raies supplémentaires par mélanges, des phénomènes de transmodulation et des saturations du signal utile. La fonction filtrage doit donc avoir un fort IP₃ et un point de compression 1dB élevé pour limiter ces inconvénients majeurs sur un récepteur. Le besoin en point de compression 1 dB et d'IP₃ ne peut pas être atteint avec l'art antérieur.

Les composants utilisés dans les filtres ont des tolérances. Pour palier cet inconvénient, si on veut conserver le meilleur facteur de forme, il est nécessaire d'avoir des réglages supplémentaires. Les dispositifs de l'art antérieur n'utilisant qu'une seule commande pour l'ensemble du filtre, ne permettent pas d'avoir un réglage adapté à toutes les fréquences d'accord. Les calculs montrent qu'il ne peut y avoir qu'un compromis.

Ces composants varient aussi en fonction de la température et requièrent une compensation en température qui s'avère toujours délicate et non reproductible par l'art antérieur.

Pour varier en fréquence et garder une bande passante constante, il est connu de l'art antérieur d'utiliser des éléments variables dans les circuits oscillants et dans le couplage, en général des varicaps (diode à capacité variable) ce qui entraîne une détérioration notable de la linéarité.

Pour les facteurs de forme requis, il faut que les commandes des varicaps soient réalisées par une impédance élevée pour né pas amortir les circuits oscillants. Malheureusement pour garantir ce temps d'accord nécessaire, l'art antérieur ne peut que pénaliser le facteur de forme pour être compatible de celui-ci.

En résumé les dispositifs de l'art antérieur présentent les inconvénients suivants :
- L'utilisation simple des varicaps dans les circuits oscillants et dans le couplage ne permet pas d'obtenir une forte linéarité,
- Les réglages ne sont jamais optimum sur toute la plage d'accord en fréquence,
- La disparité des composants nécessite des éléments de réglage complémentaires,
- Le facteur de forme du filtre varie en fonction de la fréquence et de la température,
- Le facteur de forme et la rapidité sont deux facteurs en opposition (amortissement des circuits oscillant par les résistances de polarisation des varicaps),

L'idée de la présente invention propose une architecture de filtre où la variation en fréquence est réalisée à partir de plusieurs varicaps dans chaque circuit oscillant, les varicaps étant montées en série avec une capacité fixe. Ceci permet de réduire la tension développée aux bornes de chacune de ces varicaps, tout en permettant d'avoir des points intermédiaires de branchement pour le couplage avec des éléments fixes. Ce principe permet d'obtenir des linéarités très élevées.

L'invention concerne un filtre passe bande comportant au moins un premier circuit oscillant formé de moyens inductifs (L₁, L₂) en parallèle avec des moyens capacitifs (Cᵢⱼ) et d'un deuxième circuit oscillant comportant des moyens inductifs (L₃, L₄) disposés en parallèle avec des éléments capacitifs (Cᵢⱼ), le premier circuit oscillant étant couplé au deuxième circuit oscillant **caractérisé en ce que** les moyens capacitifs (Cᵢⱼ₁) du premier circuit oscillant comportent un ensemble d'éléments capacitifs variable (C₁₁, C₁₂ , C₁₃ , C₁₄ ) en série avec une capacité fixe (C₁) et en ce que les éléments capacitifs du deuxième circuit oscillant comportent un ensemble d'éléments capacitifs variables (C₂₁, C₂₂, C₂₃, C₂₄) disposé en série avec une capacité fixe (C₂) et en ce que le premier circuit oscillant et le deuxième circuit oscillant sont couplés au moyen d'éléments capacitifs de valeur sensiblement fixes (C₃, C₄) et en ce que les éléments capacitifs de couplage sont reliés au point milieu (P₁, P₂) de deux éléments capacitifs variables.

Un élément capacitif variable (C₁₁') monté en série avec la capacité fixe comprend par exemple plusieurs capacités variables montées en parallèle (C₁₁₁' C₁₁₂').

D'autres caractéristiques et avantages de la présente invention apparaîtront mieux à la lecture de la description qui suit d'un exemple de réalisation donné à titre illustratif et nullement limitatif annexé des figures qui représentent :
- La figure 1 un schéma illustrant l'architecture de base d'un filtre selon l'invention,
- La figure 2 un exemple de filtre selon l'invention et d'un couplage spécifique,
- La figure 3 le schéma d'une application permettant de contrôler le filtre en température,
- La figure 4 un schéma de principe d'une variante de réalisation permettant de réduire le temps d'accord du filtre.

Afin de mieux faire comprendre l'objet de la présente invention, la description qui suit est donnée à titre illustratif et non limitatif pour un filtre utilisé comme un filtre d'accord.

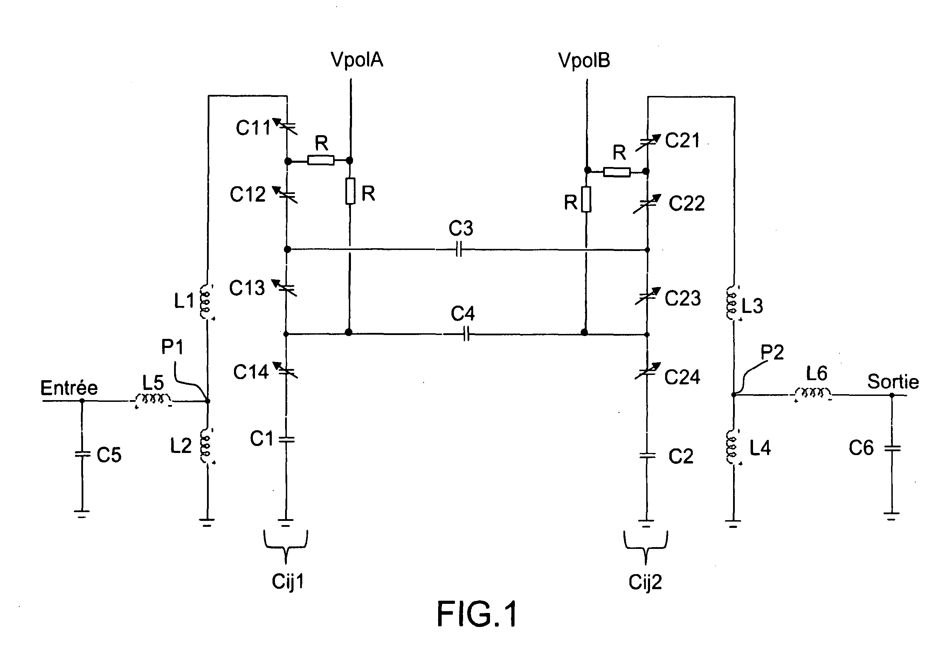

Sur la figure 1 de principe, le filtre 1 comporte :
- Une première partie I (circuit oscillant d'entrée) composée de deux inductances L₁, L₂ avec en parallèle avec un ensemble capacitif comprenant lui-même un groupe de capacités variables Cᵢⱼ (C₁₁, C₁₂, C₁₃, C₁₄) en série avec une capacité fixe C₁. Cette première partie reçoit pour piloter les éléments variables une tension d'alimentation désignée VpoleA.
- Une deuxième partie II (circuit oscillant de sortie) composée de deux inductances L₃, L₄ avec en parallèle un ensemble capacitif Cᵢⱼ constitué d'un groupe de capacités variables C₂₁, C₂₂, C₂₃, C₂₄ disposé en série avec une capacité fixe C₂. Cette deuxième partie reçoit pour piloter les éléments variables une tension d'alimentation désignée VpoleB.
- La première partie I du filtre et la deuxième partie II du filtre sont couplées, dans cet exemple de réalisation par un ensemble d'éléments fixes capacitif C₃ et C₄.
- La self L₅ et la capacité C₅ branchée au point intermédiaire L₁ et L₂ (référencé P1) permet le transfert d'impédance pour avoir 50 Ohms en entrée (In),
- La self L₆ et la capacité C₆ branchée au point intermédiaire L₃ et L₄ (référencé P₂) permet le transfert d'impédance pour avoir 50 Ohms en sortie (Out),
- Plusieurs résistances de polarisation des varicaps, R dont certaines sont représentées pour des raisons de simplification. Les valeurs de ces résistances sont très élevées, et supérieures en général à plusieurs centaines de K ohms. Leur positionnement dans le circuit est connu de l'Homme du métier.

Sur cette figure 1, la représentation de C₁₁, C₁₂, C₁₃, C₁₄, du premier circuit oscillant et de C₂₁, C₂₂, C₂₃, C₂₄ du second circuit oscillant montées en série indique en réalité chacune une varicap.

Le rapport bande passante, fréquence d'accord (ΔF/F) détermine le coefficient de surtension nécessaire du filtre ( Q) en fonction du besoin. Chaque circuit oscillant travaille à haute impédance (quelque Kohms). La schématique de branchement L₁, L₂, L₅ et C₅ permet la transformation d'impédance de travail des circuits oscillants en 50 Ohms. Il en est de même pour la sortie avec L₃, L₄, L₆ et C₆.

A partir de l'architecture du filtre choisie, il est possible, par exemple au moyen d'une simulation, et par optimisation, de déterminer les valeurs des différents éléments constituant le filtre en fonction de l'application ou de l'objectif souhaité par l'opérateur.

Avec une telle architecture, la valeur équivalente de la première série de capacité de couplage est prépondérante pour fixer la bande passante en fréquence basse du filtre et l'autre série pour les fréquences hautes. Le compromis entre les valeurs des capacités et les points de liaison entre les varicaps permet de fixer le facteur de forme du filtre.

Les varicaps sont, par exemple choisies, en prenant celles qui offrent la meilleure linéarité.

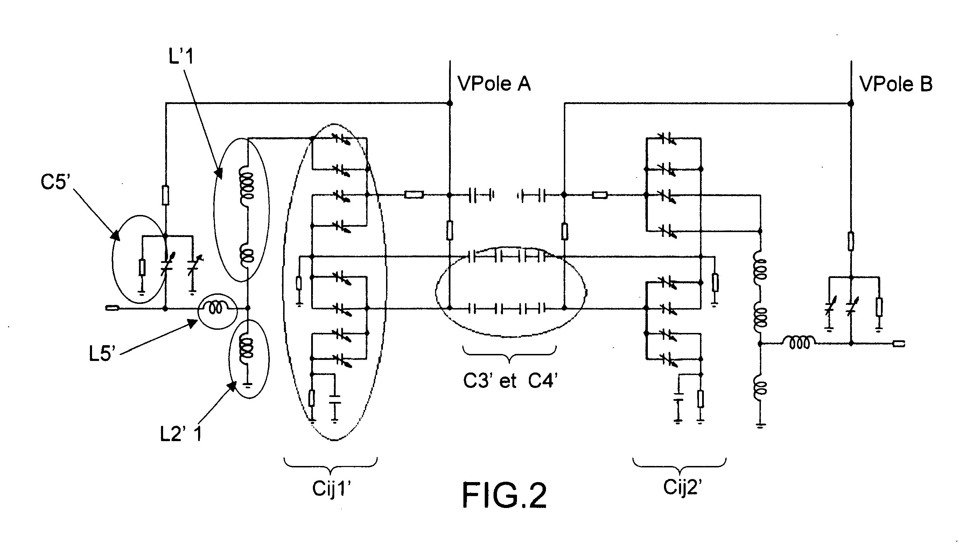

La fréquence d'accord d'un filtre étant la fréquence de résonance des circuits oscillants (LCW²=1) ; L étant la valeur de selfs et C la capacité équivalente des varicaps et de la capacité fixe mis en parallèle ; pour certaine sous gamme de filtres tractables, de façon à satisfaire à la condition LCW²=1, le filtre comporte des varicaps en parallèles pour obtenir une capacité équivalente plus grande. Un exemple est donné en figure 2. Ceci permet notamment de satisfaire au compromis encombrement, coefficient de qualité.

La figure 2 représente une réalisation dans laquelle le montage des varicaps s'effectue selon un schéma série avec la capacité fixe pour satisfaire la linéarité et parallèle pour avoir la valeur de capacité en relation avec la valeur de self (L₁+L₂ ou L₃+L₄) des circuits oscillants de ce filtre.

Le but est toujours de limiter la tension HF aux bornes des varicap et d'avoir un couplage avec des éléments fixes pour obtenir une forte linéarité.

Les éléments constituant le filtre L₁', C₅', L₅', L₂', C₃', C₄' sont équivalents aux éléments de la figure 2 désignés respectivement par L₁, C₅, L₅, L₂, C₃ et C₄.

L'ensemble capacitif Ciⱼ₁' est formé comme l'ensemble Cᵢⱼ₁ de la figure 2, d'une capacité fixe C1' et d'un groupe de varicaps C₁', C₁₂', C₁₃', C₁₄'. Chaque varicap C₁₁' comporte deux varicaps en parallèle C₁₁₁' C₁₁₂'.

La deuxième partie du filtre II est constituée selon un schéma identique. Les varicaps de la figure 2 étant remplacées par deux varicaps en parallèle.

Sans sortir du cadre de l'invention, le nombre de varicaps en parallèle n'est pas limité.

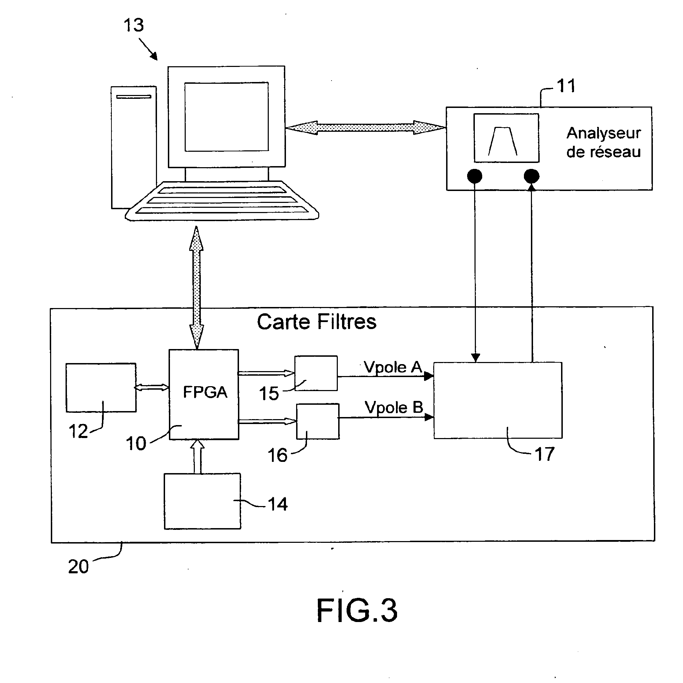

La figure 3 représente un exemple de commande de filtres tractables tels que représentés à la figure 1 et implantés sur une carte 20 selon la figure 2.

Afin de mieux contrôler l'accord de ce filtre en fréquence, les tensions VpoleA et VpoleB sont pilotées de façon indépendante, en fonction de la température et de la fréquence.

Les tensions VpoleA et VpoleB proviennent d'un dispositif numérique 10 de type FPGA dans lequel par apprentissage grâce à un analyseur de réseau 11, les tensions VpoleA et VpoleB sont numérisées, puis stockées dans une mémoire 12 pour chaque fréquence d'accord du filtre, mais également à toutes les températures. Un micro ordinateur 13 permet de piloter l'ensemble du dispositif. La carte comportant le filtre comprend aussi un capteur de température 14, permettant de disposer à chaque instant de la valeur de la température, deux convertisseurs numériques analogiques15, 16 permettant de délivrer la valeur de la tension permettant d'alimenter les deux pôles du filtre tractable 17.

La mise en oeuvre est réalisée de la façon explicitée ci-après.

L'analyseur de réseau 11 permet de contrôler le facteur de forme du filtre. Pour une fréquence donnée (via le micro ordinateur) et à une température donnée (interne au module) on fait évoluer VpoleA et VpoleB de façon indépendante jusqu'à obtenir le bon facteur de forme sur l'analyseur de réseau. Dès que le facteur de forme désirée est obtenu, les valeurs VpoleA et VpoleB correspondantes sont alors mémorisées par exemple sous forme d'une base de données dans la mémoire 12. Cette opération est réitérée pour toutes les fréquences et toutes les températures. Un programme pilote de façon synchrone le filtre, l'analyseur de réseau et l'enceinte climatique non représentée sur la figure.

La conversion numérique en tension continue par l'intermédiaire de convertisseur numérique analogique permet de retrouver les tensions VpolA et VpoIB pour chaque fréquence d'accord du filtre à une température donnée.

Selon ce mode de réalisation, chaque circuit oscillant reçoit sa propre commande des éléments variables. En utilisation, en fonction de la fréquence désirée et de la température de l'équipement, le dispositif FPGA récupère les valeurs VpoleA et VpoleB à appliquer au filtre, via les convertisseurs numériques analogiques. Le filtre étant à une certaine température, va alors se caler automatiquement à la bonne fréquence demandée par l'opérateur et avec le meilleur facteur de forme possible (celui qu'il avait acquit lors de l'apprentissage).

Ce principe permet notamment :
d'éviter
   - Tout réglage manuel,
   - D'ajouter des éléments d'ajustement,
d'avoir toujours le meilleur facteur de forme possible en fréquence et en température.

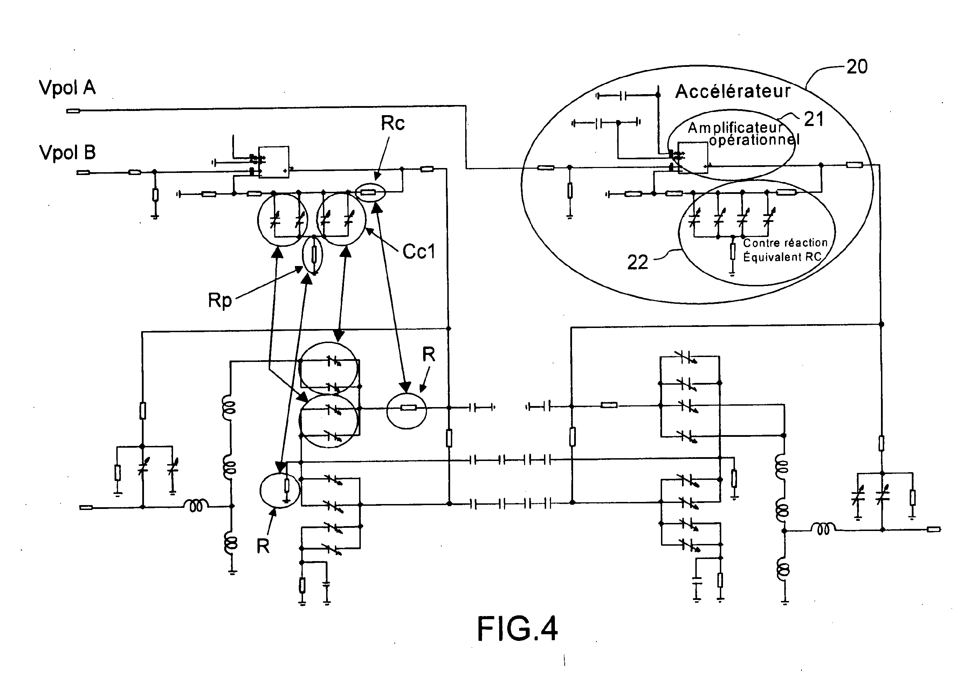

La figure 4 décrit un exemple de filtre ainsi que les circuits analogiques de commandes VpoleA et VpoleB.

Afin de ne pas amortir les circuits oscillants, les tensions de commande des capacités variables sont injectées sur les varicaps avec des résistances séries de fortes valeurs. Ceci conduit à considérer un circuit intégrateur RC (avec C égale à la capacité équivalente des varicaps C₁₁+C₁₂ ou C₁₃+C₁₄ pour le premier circuit oscillant et C₂₁+C₂₂ ou C₂₃+C₂₄ pour le deuxième circuit oscillant). La valeur de C varie donc en fonction de la fréquence d'accord désirée. Lorsque la valeur de la fréquence varie, C varie aussi. Le circuit intégrateur est donc variable en fonction de la fréquence.

Selon une variante de réalisation et de façon à réduire le temps d'accord du filtre, un accélérateur auto compensé est utilisé. Le principe consiste à insérer dans la contre réaction de l'amplificateur opérationnel un circuit intégrateur équivalent au RC du filtre ; c'est-à-dire qu'il comporte les mêmes résistances et les mêmes varicaps du filtre dans sa contre réaction.

Un accélérateur 20 comporte un amplificateur opérationnel 21 et un circuit de contre réaction 22. Le circuit de contre réaction 22 comprend une résistance Rc dont la valeur est identique à la valeur de la résistance de polarisation R (figure 1) et une résistance Rp ayant une valeur identique à la valeur de la résistance R. II comprend aussi un premier ensemble capacitif C_{c1} ayant une valeur identique à celle de C₁₁ et un deuxième ensemble capacitif C_{c2} dont la valeur est identique à celle de la valeur de C₁₂. Ces ensembles capacitifs peuvent être constitués d'une seule capacité, ou bien comme représentés sur la figure 4 de deux valeurs de capacités en parallèle.

Un tel accélérateur présente l'avantage d'être auto adapté puisque l'intégrateur RC varie de la même façon que l'intégration sur les tensions appliquée aux varicaps via les résistances séries.

L'amplificateur opérationnel crée momentanément une surtension proportionnelle à l'intégration en contre réaction. Cette surtension permet d'obtenir l'équilibre souhaité le plus rapidement possible.

Les limites sont :
- Les temps de montée propre de l'amplificateur opérationnel (V/µs),
- Les tensions d'alimentation de celui-ci.

L'invention décrite ci-dessus peut s'appliquer pour des filtres à n pôles.

## Revendications

1. Filtre passe bande comportant au moins un premier circuit oscillant formé de moyens inductifs (L₁, L₂) en parallèle avec des moyens capacitifs (Cᵢⱼ) et d'un deuxième circuit oscillant comportant des moyens inductifs (L₃, L₄) disposés en parallèle avec des éléments capacitifs (Cᵢⱼ), le premier circuit oscillant étant couplé au deuxième circuit oscillant, **caractérisé en ce que** les moyens capacitifs (Cᵢⱼ₁) du premier circuit oscillant comportent un ensemble d'éléments capacitifs variable (C₁₁, C₁₂ , C₁₃ , C₁₄ ) en série avec une capacité fixe (C₁) et **en ce que** les éléments capacitifs du deuxième circuit oscillant comportent un ensemble d'éléments capacitifs variables (C₂₁, C₂₂, C₂₃, C₂₄) disposé en série avec une capacité fixe (C₂) et **en ce que** le premier circuit oscillant et le deuxième circuit oscillant sont couplés au moyen d'éléments capacitifs de valeur sensiblement fixes (C₃, C₄) et **en ce que** les éléments capacitifs de couplage sont reliés au point milieu (P1, P2) de deux éléments capacitifs variables.

2. Filtre selon la revendication 1, **caractérisé en ce qu'**un élément capacitif variable (C₁₁') monté en série avec la capacité fixe comprend plusieurs capacités variables montées en parallèle (C₁₁₁', C₁₁₂').

3. Filtre selon la revendication 1, **caractérisé en ce qu'**il comporte deux circuits oscillants.

4. Dispositif de filtrage **caractérisé en ce qu'**il comporte un filtre à plusieurs pôles (n) selon l'une des revendications 1 à 3 et **en ce qu'**il comporte des commandes indépendantes pour chaque pôle.

5. Dispositif de filtrage comportant au moins un filtre selon l'une des revendications 1 à 3 et **caractérisé en ce qu'**il comporte au moins un amplificateur opérationnel (21), un circuit de contre réaction (22), le circuit de contre réaction (22) comprenant une résistance (Rc) ayant une valeur sensiblement identique à la valeur de la résistance de polarisation R des éléments capacitifs variables du filtre et une résistance (Rp) ayant une valeur sensiblement identique à la valeur de la résistance R et un premier ensemble capacitif C_{c1} ayant une valeur identique à celle de C₁₁ et un deuxième ensemble capacitif C_{c2} dont la valeur est identique à celle de la valeur de C₁₂.

## Claims

1. A band-pass filter comprising at least one first oscillator circuit formed by inductive means (L₁, L₂) in parallel with capacitive means (Cᵢⱼ) and a second oscillator circuit comprising inductive means (L₃, L₄) in parallel with capacitive elements (Cᵢⱼ), the first oscillator circuit being coupled to the second oscillator circuit, **characterised in that** the capacitive means (Cᵢⱼ₁) of the first oscillator circuit include a group of variable capacitive elements (C₁₁, C₁₂, C₁₃, C₁₄) connected in series with a fixed capacitor (C₁) and **in that** the capacitive elements of the second oscillator circuit include a group of variable capacitive elements (C₂₁, C₂₂, C₂₃, C₂₄) connected in series with a fixed capacitor (C₂) and **in that** the first oscillator circuit and the second oscillator circuit are coupled by means of capacitive elements with an essentially fixed value (C₃, C₄) and **in that** the coupling capacitive elements are joined at the central point (P₁, P₂) of two variable capacitive elements.

2. Filter according to claim 1, **characterised in that** a variable capacitive element (C₁₁') connected in series with the fixed capacitor comprises several variable capacitors connected in parallel (C₁₁₁', C₁₁₂').

3. Filter according to claim 1, **characterised in that** it comprises two oscillator circuits.

4. A device for filtering, **characterised in that** it comprises a filter with several poles (n), according to one of claims 1 to 3, and **in that** it comprises independent commands for each pole.

5. A device for filtering comprising at least one filter according to one of claims 1 to 3, and **characterised in that** it comprises at least one operational amplifier (21), a negative feedback circuit (22), said negative feedback circuit (22) comprising a resistor (Rc) having a value which is essentially identical to the value of the polarisation resistor R for the variable capacitive elements of the filter and a resistor (Rp) having a value which is essentially identical to the value of the resistor R and a first capacitive group C_{c1} having a value which is identical to C₁₁ and a second capacitive group C_{c2}, the value of which is identical to the value of C₁₂.

## Patentansprüche

1. Bandpassfilter, der wenigstens eine erste Oszillatorschaltung, die durch induktive Mittel (L₁, L₂) parallel zu kapazitiven Mitteln (Cᵢⱼ) gebildet werden, und eine zweite Oszillatorschaltung umfasst, die induktive Mittel (L₃, L₄) umfasst, die parallel zu kapazitiven Elementen (Cᵢⱼ) geschaltet sind, wobei die erste Oszillatorschaltung mit der zweiten Oszillatorschaltung verbunden ist, **dadurch gekennzeichnet, dass** die kapazitiven Mittel (Cᵢⱼ₁) der ersten Oszillatorschaltung eine Gruppe von variablen kapazitiven Elementen (C₁₁, C₁₂, C₁₃, C₁₄) in Serie mit einem festen Kondensator (C₁) beinhalten, und **dadurch**, dass die kapazitiven Elemente der zweiten Oszillatorschaltung eine Gruppe von variablen kapazitiven Elementen (C₂₁, C₂₂, C₂₃, C₂₄) beinhalten, die in Serie mit einem festen Kondensator (C₂) geschaltet sind, und **dadurch**, dass die erste Oszillatorschaltung und die zweite Oszillatorschaltung mittels kapazitiver Elemente mit im Wesentlichen festen Werten (C₃, C₄) verbunden sind, und **dadurch**, dass die kapazitiven Verbindungselemente am Mittelpunkt (P₁, P₂) von zwei variablen kapazitiven Elementen verknüpft sind.

2. Filter nach Anspruch 1, **dadurch gekennzeichnet, dass** ein mit dem festen Kondensator in Serie geschaltetes variables kapazitives Element (C₁₁') mehrere parallel geschaltete variable Kondensatoren (C₁₁₁', C₁₁₂') umfasst.

3. Filter nach Anspruch 1, **dadurch gekennzeichnet, dass** er zwei Oszillatorschaltungen umfasst.

4. Filtervorrichtung, **dadurch gekennzeichnet, dass** sie einen Filter mit mehreren Polen (n) nach einem der Ansprüche 1 bis 3 umfasst, und **dadurch**, dass sie unabhängige Befehle für jeden Pol umfasst.

5. Filtervorrichtung, die wenigstens einen Filter nach einem der Ansprüche 1 bis 3 umfasst, und **dadurch gekennzeichnet, dass** sie Folgendes umfasst: wenigstens einen Operationsverstärker (21), eine Gegenkopplungsschaltung (22), wobei die Gegenkopplungsschaltung (22) einen Widerstand (Rc) mit einem Wert umfasst, der mit dem Wert des Polarisationswiderstands R der variablen kapazitiven Elemente des Filters im Wesentlichen identisch ist, und einen Widerstand (Rp) mit einem Wert, der mit dem Wert des Widerstand R im Wesentlichen identisch ist, und eine erste kapazitive Gruppe C_{c1} mit einem Wert, der mit dem Wert von C₁₁ identisch ist, und einer zweiten kapazitiven Gruppe C_{c2} mit einem Wert, der mit dem Wert von C₁₂ identisch ist.
